# FASCICULE DE BREVET EUROPEEN

(11) **EP 0 674 804 B1**
(45) Date de publication et mention de la délivrance du brevet: **21.08.1996**
(21) Numéro de dépôt: 94931068.4
(22) Date de dépôt: 17.10.1994
(51) Int. Cl.: H01J 9/46, C23C 14/56, H01J 9/02

(54) **INSTALLATION DE DEPOT D'UN MATERIAU METALLIQUE SUR UNE PLAQUE PAR EVAPORATION**
BESCHICHTUNGSVORRICHTUNG ZUM AUFDAMPFEN VON METALLISCHEM MATERIAL AUF EIN SUBSTRAT
METAL VAPOUR DEPOSITION UNIT

(30) Priorité: 18.10.1993 FR 9312709
(43) Date de publication de la demande: 04.10.1995
(73) Titulaire: PIXEL INTERNATIONAL S.A., F-13790 Rousset (FR)
(72) Inventeur: PEPI, Richard, F-83470 Pourrières (FR); GARCIA, Michel, F-13290 Les Milles (FR); MEYER, Robert, F-38330 Saint-Nazaire-les-Eymes (FR)
(74) Mandataire: de Beaumont, Michel
(86) Numéro de dépôt international: FR9401195
(87) Numéro de publication internationale: WO9511517

(56) Documents cités:
- EP-A- 0 428 358
- US-A- 4 607 593
- JOURNAL OF VACUUM SCIENCE AND TECHNOLOGY: PART A, vol.7, no.6, 1989, NEW YORK US pages 3208 - 3212 X K WANG ET AL 'Computer-controlled, three-electron-gun, multisubstrate evaporator for the preparation of multilayer thin films'
- JOURNAL OF APPLIED PHYSICS., vol.39, 1968, NEW YORK US pages 3504 - 3505 C A SPINDT 'A thin-film field emmision cathode'
- PATENT ABSTRACTS OF JAPAN vol. 10, no. 240 (E-429) (2296) 19 Août 1986 & JP,A,61 071 533 (FUTABA CORP.)
- APPLIED OPTICS, vol.28, no.14, Juillet 1989, NEW YORK US pages 2694 - 2696 C J HAYDEN 'Large area coatings with uniform thickness fabrication in a small vacuum chamber'

## Description

La présente invention concerne une installation d'évaporation d'un matériau métallique sur une surface à traiter. Elle s'applique plus particulièrement à la réalisation de micropointes d'émission électronique déposées par évaporation sous vide d'un matériau conducteur sur une cathode d'un écran plat de visualisation.

Un tel écran à micropointes est essentiellement constitué d'une cathode à micropointes et d'une grille pourvue de trous correspondant aux emplacements des micropointes. La cathode est placée en regard d'une anode cathodoluminescente dont un substrat de verre constitue la surface d'écran.

Le principe de fonctionnement et le détail de la constitution d'un exemple d'écran à micropointes sont décrits dans le brevet américain numéro 4 940 916 du Commissariat à l'Energie Atomique.

Ce dispositif utilise le champ électrique créé entre l'anode et la cathode pour que des électrons soient extraits des micropointes vers une couche cathodoluminescente de l'anode, sous la commande de la grille.

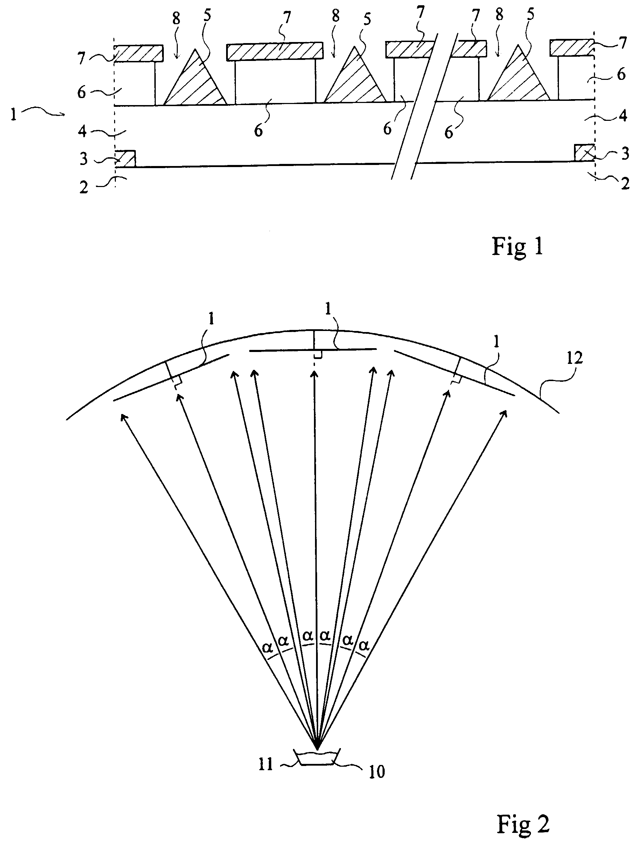

La figure 1 représente partiellement et en coupe la structure d'une plaque de cathode-grille 1 d'un écran à micropointes.

La plaque 1 est généralement constituée de couches déposées successivement sur un substrat isolant 2. Une couche conductrice est déposée sur le substrat 2, puis est gravée selon un motif de mailles pour former des conducteurs de cathode 3. Une couche résistive 4 est ensuite déposée sur ces conducteurs de cathode 3. Cette couche résistive 4 a pour objet de protéger chaque micropointe 5 contre un excès de courant à l'amorçage d'une micropointe 5. Une couche isolante 6 est déposée sur la couche résistive 4 pour isoler les conducteurs de cathode 3 de la grille 7 formée d'une couche conductrice. Des trous 8 sont pratiqués dans les couches 6 et 7 pour recevoir les micropointes 5.

Le dépôt des micropointes 5 s'effectue classiquement par évaporation d'un matériau conducteur, par exemple de molybdène. Une couche d'élimination par soulèvement, par exemple du nickel, est au préalable réalisée sur la surface de la grille 7, et également sur les bords des trous 8. On peut ainsi éliminer le matériau constitutif des micropointes vaporisé à ces emplacements.

Un problème qui se pose lors de la formation des micropointes est que les installations classiques d'évaporation d'un matériau métallique ne sont pas adaptées à la réalisation de dépôts sous incidence quasi-normale sur des plaques de grandes dimensions.

En effet, comme il ressort de la figure 1, les micropointes 5 doivent être déposées dans le fond des trous 8 mais le matériau évaporé ne doit ni remplir les trous 8, ni se déposer sur les parois des trous dans la couche d'isolement 6. Dans le cas contraire, le surplus de matériau conducteur ne pourrait être éliminé sélectivement par rapport aux micropointes 5. La couche d'élimination par soulèvement à laquelle on a généralement recours ne recouvre que les surfaces de la couche de grille 7. L'incidence du faisceau d'évaporation doit donc être quasi-normale à la plaque 1 pour éviter le dépôt de matériau hors des zones souhaitées.

De plus, une plaque 1 donnée d'un écran est formée d'une seule pièce. De ce fait, l'incidence quasi-normale du faisceau d'évaporation doit être obtenue sur toute la surface de la plaque.

La figure 2 représente schématiquement une installation classique d'évaporation d'un matériau métallique du type utilisée pour former les micropointes 5.

L'évaporation d'un matériau métallique 10 s'effectue sous vide, au moyen d'un creuset 11 contenant le matériau à évaporer. Le contenu du creuset 11 est chauffé et vaporisé au moyen d'un dispositif de bombardement électronique (non représenté). Classiquement, une installation d'évaporation comprend un carrousel 12 à mouvement épicycloïdal. Des plaques à traiter 1 sont accrochées à la surface interne du carrousel 12 qui est concave vers le creuset 11. Une source d'évaporation, constituée du creuset 11 et du dispositif de bombardement électronique, est placée au centre du carrousel 12. La rotation du carrousel 12 et des plaques 1 permet d'obtenir un dépôt homogène.

Le besoin d'un faisceau d'évaporation présentant une incidence quasi-normale au plan des plaques 1 entraîne, pour des plaques de grandes dimensions, que la source d'évaporation doit être placée à une très grande distance des plaques. Ceci afin que l'angle α d'incidence maximale du faisceau d'évaporation qui atteint une plaque donnée, soit très faible. En d'autres termes, le carrousel 12 doit présenter un rayon important pour que le cône de matériau évaporé atteignant par sa base une plaque 1 donnée, présente un angle très faible. Typiquement, l'angle maximal d'incidence du faisceau sur une plaque 1 donnée doit être compris entre 5 et 15°. Par exemple, pour une plaque 1 rectangulaire de 20 cm par 30 cm, un angle maximal d'incidence d'environ 9° conduit à une distance entre les plaques 1 et le creuset 11 d'environ 1 m.

Une telle distance conduit à prévoir des installations fort encombrantes.

Un autre inconvénient provient du fait que les étapes de chargement et de déchargement d'une nouvelle série de plaques 1 dans le carrousel 12 entraîne une pollution du vide sous lequel doit être réalisée l'évaporation, ce qui diminue le rendement de l'installation.

La présente invention vise à pallier ces inconvénients en proposant une installation qui permette une évaporation sous incidence quasi-normale tout en restant compacte et à fort débit.

L'invention vise également à éviter une pollution du vide sous lequel est réalisée l'évaporation et à autoriser un traitement en chaîne des plaques.

Pour atteindre ces objets, la présente invention prévoit une installation de dépôt par évaporation d'un matériau métallique sur une plaque, comportant une enceinte sous vide hermétique équipée en partie haute d'un convoyeur linéaire d'au moins une plaque, surface à traiter dirigée vers le bas, et en partie basse d'au moins deux sources d'évaporation réparties perpendiculairement à la direction de convoyage, chaque source étant associée à un collimateur de son faisceau de matière évaporée, et les sources d'évaporation et leur collimateur associé étant agencés de manière à traiter toute la surface de la plaque sous une incidence quasi-normale.

Selon un mode de réalisation de l'invention, le convoyeur comporte des moyens pour maintenir la plaque parallèle à la direction de convoyage mais inclinée avec un angle donné par rapport à l'horizontale, chaque source d'évaporation étant associée à un collimateur agencé pour définir un cône d'évaporation dont l'axe présenté un angle donné par rapport à la surface du matériau à évaporer.

Selon un mode de réalisation de l'invention, les collimateurs sont constitués d'un masque ouvert circulairement et disposé entre la plaque et les sources d'évaporation.

Selon un mode de réalisation de l'invention, l'enceinte est limitée par deux sas, respectivement d'entrée et de sortie de la plaque.

Selon un mode de réalisation de l'invention, une plaque à traiter comporte un empilement de couches constitutives d'une cathode et d'une grille d'un écran plat de visualisation, le matériau à évaporer étant un matériau conducteur de formation de micropointes d'émission électronique dans des trous que comportent la grille et une couche d'isolement de la grille par rapport à des conducteurs de cathode.

L'invention concerne également un procédé de formation de micropointes d'émission électronique d'un écran plat de visualisation déposées par évaporation sous vide d'un matériau conducteur sur une cathode, consistant à amener une plaque dans une enceinte sous vide hermétique et à déplacer la plaque linéairement devant au moins deux sources d'évaporation, réparties perpendiculairement à la direction de déplacement, dudit matériau chaque source étant associée à un collimateur de définition d'un cône d'évaporation de petit angle, les sources d'évaporation et leur collimateur associé étant agencés de manière à traiter toute la surface de la plaque.

Selon un mode de réalisation de l'invention, l'angle du cône défini par chaque collimateur est compris entre 5 et 15°.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :
les figures 1 et 2 qui ont été décrites précédemment sont destinées à exposer l'état de la technique et le problème posé ;
la figure 3 est une vue en coupe longitudinale d'un premier mode de réalisation d'une installation de dépôt par évaporation d'un matériau métallique selon l'invention ;
la figure 4 est une vue de dessus de l'installation représentée à la figure 3 ; et
la figure 5 est une vue en coupe transversale d'un deuxième mode de réalisation d'une installation de dépôt par évaporation selon l'invention.

Pour des raisons de clarté, les représentations des figures ne sont pas à l'échelle et les mêmes éléments ont été désignés par les mêmes références aux différentes figures.

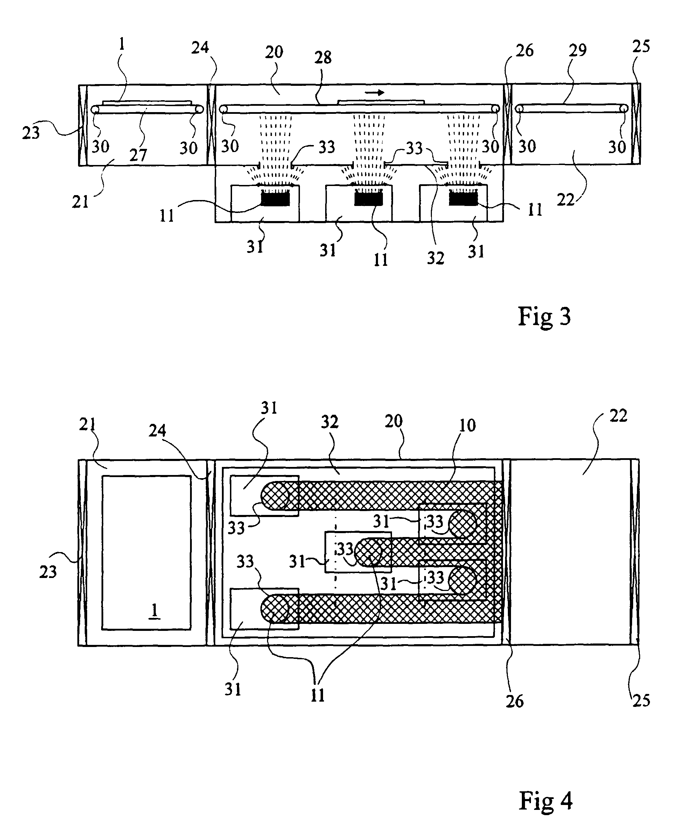

Comme le montrent les figures 3 et 4, une installation selon l'invention comporte une enceinte hermétique 20 formant tunnel et limitée par deux sas, respectivement d'entrée 21 et de sortie 22. Chaque sas est limité par des portes, respectivement 23 et 24, 25 et 26.

Une plaque 1 introduite au moyen du sas 21 est acheminée vers l'enceinte 20 au moyen d'un convoyeur 27 que comporte le sas 21. Ce convoyeur 27 est de préférence aligné avec un convoyeur 28 dont est équipée l'enceinte 20 dans sa partie haute. Côté sortie, un convoyeur 29 du sas 22 est aligné avec le convoyeur 28 de l'enceinte 20. Le trajet du convoyeur 28 dans l'enceinte est linéaire et horizontal au moins dans une zone de traitement par évaporation. De préférence, le trajet du convoyeur 28 est linéaire et horizontal dans toute l'enceinte 20 depuis le sas d'entrée 21 jusqu'au sas de sortie 22.

Les convoyeurs 27, 28 et 29 sont par exemple constitués de deux bandes parallèles et écartées l'une de l'autre, entraînées par des rouleaux 30. Les plaques 1 sont transportées, surface à traiter vers le bas, en reposant par deux de leurs bords sur les bandes des convoyeurs. On pourra également avoir recours par exemple à des convoyeurs aériens, constitués de rails desquels pendent des luges dont les patins constituent supports pour deux des bords des plaques 1. Les plaques 1 pourraient encore être suspendues à des convoyeurs aériens au moyen de griffes de préhension des bords des plaques.

Des sources d'évaporation 31 sont disposées dans la partie basse de l'enceinte 20. Ces sources d'évaporation sont constituées de creusets 11 contenant le matériau à évaporer et de dispositifs de bombardement électronique (non représentés). Les sources 31 sont de préférence réparties dans la zone de traitement de manière à traiter toute la surface de la plaque 1 durant sont trajet dans l'enceinte 20. En d'autres termes, l'enceinte 20 comporte plusieurs sources d'évaporation 31 disposées perpendiculairement à l'axe de convoyage des plaques 1, chaque source d'évaporation 31 couvrant une zone déterminée dans la largeur de l'enceinte 20.

Chaque source d'évaporation 31 est associée à un collimateur du faisceau de matériau évaporé qu'elle émet. Ce collimateur est interposé entre le creuset 11 de la source d'évaporation et la surface à traiter de la plaque 1. Les collimateurs sont par exemple constitués d'un masque 32 interposé entre les creusets 11 et la surface à traiter de la plaque 1. Le masque 32 est par exemple constitué d'une tôle ouverte circulairement au droit de chaque creuset 11.

Le choix du diamètre de chaque ouverture 33 du masque 32 dépend de la plage d'angles d'incidences souhaitée pour l'évaporation du matériau 10, et de la distance qui sépare les creusets du masque 32.

Dans la représentation des figures 3 et 4, les sources d'évaporation 31 ont été représentées réparties le long de l'enceinte 20. Elles pourraient également être alignées selon une direction perpendiculaire à l'axe de convoyage. On veillera cependant à ce que les zones, couvertes par les bases des cônes d'évaporation sur la plaque 1 et définies par les ouvertures 33, recouvrent toute la largeur de la plaque 1. De plus, on veillera à ce que les bases des cônes d'évaporation de deux sources 31 dont les zones de couverture sont voisines, se chevauchent de façon optimale afin de ne pas nuire à la régularité du dépôt.

Ainsi, l'invention permet de réaliser l'évaporation du matériau sous une incidence quasi-normale à la surface à traiter tout en réduisant la distance qui sépare les plaques 1 des sources d'évaporation. Cette réduction de distance est obtenue grâce à la multiplication des sources d'évaporation associées à une même plaque. Cette multiplication des sources réduit la surface de base de chaque cône d'évaporation et permet ainsi de réduire la distance entre les plaques et les creusets.

De plus, l'acheminement linéaire des plaques permet de rapporter la distance entre les plaques 1 et un nombre de creusets 11 donné, non plus au grand côté, mais au petit côté d'une plaque rectangulaire.

En outre, le recours à un masque 32 ouvert uniquement au droit des creusets 11 et dont les ouvertures 33 sont dimensionnées en fonction de la taille des plaques, permet d'éviter une dispersion du matériau dans l'enceinte 20 en limitant les directions d'évaporation aux directions utiles.

En reprenant l'exemple exposé en relation avec la figure 2, il suffit désormais que la plaque 1 soit placée à environ 13 cm de cinq creusets 11 dont les cônes d'évaporation présentent un diamètre à la base de 4 cm. De tels cônes d'évaporation peuvent par exemple être obtenus au moyen d'un masque 32 présentant des ouvertures circulaires 33 d'environ 2 cm de diamètre placé à environ 6 cm des creusets 11. Comme une plaque 1 donnée reçoit du matériau évaporé provenant de cinq creusets 11 affectés chacun à une partie de la surface de la plaque, la vitesse de dépôt augmente d'un facteur cinq par rapport au cas de la figure 2.

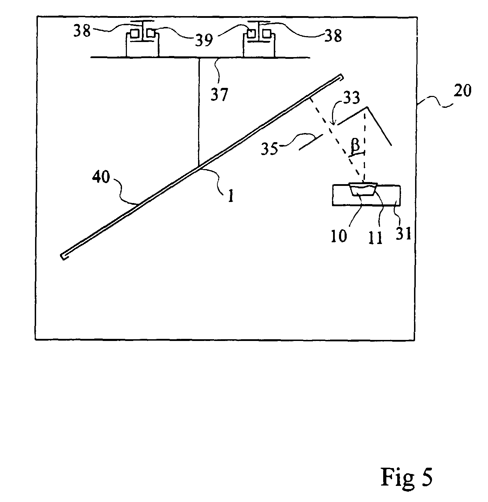

La figure 5 illustre un autre mode de réalisation d'une installation selon la présente invention.

Selon ce mode de réalisation, les plaques 1 sont toujours transportées linéairement dans l'enceinte 20 au moyen d'un convoyeur 34, mais en étant inclinées d'un angle donné par rapport à l'horizontale.

Chaque source d'évaporation 31 est associée à un collimateur 35 qui définit un cône d'évaporation selon une direction qui présente un angle β par rapport à la normale à la surface du matériau 10 contenu dans le creuset 11. Le cône défini par chaque collimateur 35 est dirigé vers la plaque 1. Chaque collimateur 35 est par exemple comme précédemment constitué par une tôle comportant une ouverture circulaire 33 de définition du cône d'évaporation. De préférence, chaque tôle constitutive d'un collimateur 35 recouvre le creuset 11 auquel elle est associée afin d'éviter une dispersion inutile du matériau dans l'enceinte 20.

Les sources d'évaporation 31 sont toujours réparties perpendiculairement à la direction de convoyage, mais également en hauteur pour que la distance entre la plaque 1 et tous les creusets 11 soit constante. Pour des raisons de clarté, seule une source d'évaporation 31 a été représentée à la figure 5. En pratique, on prévoira plusieurs sources d'évaporation pour que chaque cône d'évaporation ne traite par sa base, qu'une bande de la plaque 1, et ainsi permettre comme précédemment de placer les plaques à faible distance des creusets 11.

Les plaques 1 devant être inclinées, on aura de préférence recours à un convoyeur aérien. Ce convoyeur 34 est par exemple constitué de traverses 37 suspendues à deux rails parallèles 38 par l'intermédiaire de galets de roulement 39. Les plaques 1 sont suspendues aux traverses au moyen de supports à griffes 40.

Un tel mode de réalisation permet d'éviter que des éruptions de matière, qui sont susceptibles de se produire essentiellement selon la normale à la surface du matériau contenu dans le creuset, ne viennent se déposer sur les plaques ce qui les rendraient inutilisables.

Bien entendu, la présente invention est susceptible de diverses variantes et modifications qui apparaîtront à l'homme de l'art. En particulier, chacun des dispositifs décrits pourra être remplacé par un ou plusieurs éléments remplissant la même fonction. Par exemple, les convoyeurs pourront être constitués par tout moyen approprié pourvu qu'ils permettent de laisser accessible la surface des plaques dirigée vers le bas et de convoyer les plaques linéairement selon une direction horizontale.

En outre, le choix des dimensions respectives des ouvertures des collimateurs et de la distance qui sépare ces collimateurs des sources d'évaporation, dépend de l'angle d'incidence souhaité pour le matériau évaporé, de la taille des plaques à traiter et de la distance qui les séparent des sources d'évaporation.

## Revendications

1. Installation de dépôt par évaporation d'un matériau métallique sur une plaque, caractérisée en ce qu'elle comporte une enceinte (20) sous vide hermétique équipée en partie haute d'un convoyeur linéaire (28 ; 34) d'au moins une plaque (1), surface à traiter dirigée vers le bas, et en partie basse d'au moins deux sources d'évaporation (31) réparties perpendiculairement à la direction de convoyage, chaque source étant associée à un collimateur (32, 33 ; 35) de son faisceau de matière évaporée, et les sources d'évaporation et leur collimateur associé étant agencés de manière à traiter toute la surface de la plaque (1) sous une incidence quasi-normale.

2. Installation de dépôt par évaporation d'un matériau métallique sur une plaque selon la revendication 1, caractérisée en ce que ledit convoyeur (34) comporte des moyens pour maintenir la plaque (1) parallèle à la direction de convoyage mais inclinée avec un angle donné par rapport à l'horizontale, et en ce que chaque source d'évaporation (31) est associée à un collimateur (35) agencé pour définir un cône d'évaporation dont l'axe présente un angle (β) donné par rapport à la surface du matériau à évaporer.

3. Installation de dépôt par évaporation d'un matériau métallique sur une plaque selon la revendication 1 ou 2, caractérisée en ce que lesdits collimateurs sont constitués d'un masque (32) ouvert circulairement et disposé entre la plaque (1) et lesdites sources d'évaporation (31).

4. Installation de dépôt par évaporation d'un matériau métallique sur une plaque selon l'une quelconque des revendications 1 à 3, caractérisée en ce que ladite enceinte (20) est limitée par deux sas, respectivement d'entrée (21) et de sortie (22) de la plaque (1).

5. Installation de dépôt par évaporation d'un matériau métallique sur une plaque selon l'une quelconque des revendications 1 à 4, caractérisée en ce qu'une plaque à traiter (1) comporte un empilement de couches (2, 3, 4, 6, 7) constitutives d'une cathode et d'une grille d'un écran plat de visualisation, et en ce que ledit matériau à évaporer est un matériau conducteur de formation de micropointes (5) d'émission électronique dans des trous (8) que comportent la grille (7) et une couche d'isolement (6) de la grille par rapport à des conducteurs de cathode (3).

6. Procédé de formation de micropointes d'émission électronique d'un écran plat de visualisation déposées par évaporation sous vide d'un matériau conducteur sur une cathode, caractérisé en ce qu'il consiste à amener une plaque (1) dans une enceinte sous vide hermétique (20) et à déplacer la plaque linéairement devant au moins deux sources d'évaporation (31), réparties perpendiculairement à la direction de déplacement, dudit matériau, chaque source étant associée à un collimateur (32, 33 ; 35) de définition d'un cône d'évaporation de petit angle, les sources d'évaporation et leur collimateur associé étant agencés de manière à traiter toute la surface de la plaque.

7. Procédé de formation de micropointes d'émission électronique d'un écran plat de visualisation selon la revendication 6, caractérisé en ce que l'angle du cône défini par chaque collimateur (32, 33 ; 35) est compris entre 5 et 15°.

## Patentansprüche

1. Einrichtung bzw. Anlage zur Dampfabscheidung bzw. zum Sputtern eines metallischen Materials auf eine platte, dadurch **gekennzeichnet**, daß sie folgendes aufweist: eine luftdichte Vakuumkammer (20), die an ihrem oberen Teil mit einer linearen Fördervorrichtung (28; 34) versehen ist, welche mindestens eine Platte (1) trägt, wobei die zu behandelnde Plattenoberfläche nach unten gedreht ist, und an ihrem unteren Teil mit mindestens zwei Dampfabscheidungs- bzw. Sputterquellen (31) versehen ist, die senkrecht zu der Bewegungsrichtung der Fördervorrichtung angeordnet sind, wobei jede Quelle mit einem Kollimator (32, 33; 35) seines Strahls aus Sputtermaterial assoziiert ist, wobei die Sputterquellen und ihr assozierter Kollimator derart angeordnet ist, daß sie die gesamte Oberfläche der Platte (1) mit einem im wesentlichen senkrechten bzw. normalen Auftreffen beschichten bzw. überziehen.

2. Einrichtung bzw. Anlage gemäß Anspruch 1, dadurch gekennzeichnet, daß die Fördervorrichtung (34) Mittel umfaßt zum Halten der Platte (1) parallel zu der Förderrichtung, aber gekippt mit einem vorbestimmten Winkel bezüglich der Horizontalebene, und daß jede Sputterquelle (31) mit einem Kollimator (35) assoziiert ist, der angeordnet ist, um einen Sputterkegel zu definieren, dessen Achse einen vorbestimmten Winkel (β) bezüglich der Oberfläche des verdampften Materials besitzt.

3. Einrichtung bzw. Anlage gemäß Anspruch 1 oder 2, dadurch gekennzeichnet, daß die Kollimatoren durch eine Maske (32) mit einer kreisförmigen Öffnung gebildet sind, die zwischen der Platte (1) und den Sputterquellen (31) angeordnet ist.

4. Einrichtung bzw. Anlage gemäß einem der Ansprüche 1 bis 3, dadurch gekennzeichnet, daß die Vakuumkammer (20) durch eine Eingangsschleusenkammer (21) und eine Ausgangsschleusenkammer (22) begrenzt wird.

5. Einrichtung bzw. Anlage gemäß einem der Ansprüche 1 bis 4, dadurch gekennzeichnet, daß eine zu überziehende bzw. zu beschichtende Platte (1) einen Stapel von Schichten (2, 3, 4, 6, 7) aufweist, die eine Kathode und ein Gitter auf einem Flachbildschirm bilden, und daß das zu verdampfende Material ein leitendes Material ist zum Bilden von elektronenemittierenden Mikrospitzen (5) in Löchern (8), die in dem Gitter (7) und einer Schicht (6) zum Isolieren des Gitters von den Kathodenleitern (3) gebildet sind.

6. Verfahren zum Bilden von elektronenemittierenden Mikrospitzen auf einem Flachbildschirm, wobei die Mikrospitzen durch Vakuumdampfabscheidung eines leitenden Materials auf einer Kathode abgeschieden werden, dadurch **gekennzeichnet**, daß das Verfahren folgendes aufweist: Befördern bzw. Transportieren einer Platte (1) in eine luftdichte Vakuumkammer (20) und lineares Bewegen der Platte vor mindestens zwei Sputterquellen (31) des Materials, welche senkrecht zu der Bewegungsrichtung angeordnet sind, wobei jede Quelle mit einem Kollimator (32, 33; 35) assoziiert ist, welcher einen Sputterkegel mit kleinem Winkel definiert, wobei die Sputterquellen und der assoziierte Kollimator derart angeordnet ist, daß sie die gesamte Oberfläche der Platte behandeln.

7. Verfahren gemäß Anspruch 6, dadurch gekennzeichnet, daß der Winkel des von jedem Kollimator (32, 33; 35) definierten Kegels im Bereich von 5° bis 15° liegt.

## Claims

1. A device for sputtering a metallic material on a plate, characterized in that it comprises an airtight vacuum chamber (20) provided in its higher portion with a linear conveyor (28;34) carrying at least one plate (1), the plate surface to be processed being turned downward, and in its lower portion of at least two sputtering sources (31) arranged perpendicularly to the moving direction of the conveyor, each source being associated with a collimator (32,33;35) of its beam of sputtered material, the sputtering sources and their associated collimators being arranged to coat the whole width of the plate (1) under a substantially normal incidence.

2. The device of claim 1, characterized in that said conveyor (34) includes means for maintaining the plate (1) parallel with the conveying direction, but tilted according to a determined angle with respect to the horizontal plane, and in that each sputtering source (31) is associated with a collimator (35) that is disposed in order to define a sputtering cone whose axis has a determined angle (β) with respect to the surface of the vaporized material.

3. The device of claim 1 or 2, characterized in that said collimators are constituted by a mask (32) circularly apertured and disposed between the plate (1) and said sputtering sources (31).

4. The device of claim 1, characterized in that said vacuum chamber (20) is ended by an input lock chamber (21) and an output lock chamber (22).

5. The device of any of claims 1 to 4, characterized in that a plate (1) to be coated comprises a pile of layers (2, 3, 4, 6, 7) constituting a cathode and a grid of a flat display screen, and in that said material to be evaporated is a conductive material for constituting electron emission microtips (5) in holes (8) formed in the grid (7) and a layer (6) for insulating the grid from the cathode conductors (3).

6. A method for forming electron emission microtips of a flat display screen, deposited through vacuum evaporation of a conductive material on a cathode, characterized in that it consists of conveying a plate (1) into an airtight vacuum chamber (20) and linearly moving the plate in front of at least two sputtering sources (31) of said material, arranged perpendicularly to the moving direction, each source being associated with a collimator (32,33;35) defining a small-angle sputtering cone, the sputtering sources and the associated collimators being arranged so as to process the whole surface of the plate.

7. The method of claim 6, characterized in that the angle of the cone defined by each collimator (32,33;35) ranges from 5° to 15°.
